# EUROPEAN PATENT SPECIFICATION

(11) **EP 4 489 180 B1**
(45) Date of publication and mention of the grant of the patent: **14.10.2026**
(21) Application number: 24184213.7
(22) Date of filing: 25.06.2024
(51) Int. Cl.: H01M 10/42, H01M 10/48, G01R 31/392, G01R 31/367, G01R 31/389, G01R 31/385

(54) **METHOD FOR PREDICTING THERMAL RUNAWAY IN LITHIUM BATTERY BASED ON CAPACITIVE REACTANCE ANALYSIS**
VERFAHREN ZUR VORHERSAGE VON THERMISCHEM DURCHGEHEN IN EINER LITHIUMBATTERIE AUF BASIS VON KAPAZITIVER REAKTANZANALYSE
PROCÉDÉ DE PRÉDICTION D'EMBALLEMENT THERMIQUE DANS UNE BATTERIE AU LITHIUM SUR LA BASE D'UNE ANALYSE DE RÉACTANCE CAPACITIVE

(30) Priority: 27.06.2023 CN 202310762156
(43) Date of publication of application: 08.01.2025
(73) Proprietor: Yantai Chungway New Energy Technology Co., Ltd., Yantai City, Shandong 264006 (CN)
(72) Inventor: Li, Mingming, Yantai (CN); Liu, Tianyu, Yantai (CN); Bai, Wenhao, Yantai (CN); Fang, Xiangming, Yantai (CN); Tang, Ge, Yantai (CN); Liu, Fuhua, Yantai (CN); Fan, Shaogui, Yantai (CN)
(74) Representative: Monteiro Alves, Inês

(56) References cited:
- CN-A- 114 689 195
- CN-A- 115 327 392
- US-A1- 2020 280 108
- US-A1- 2021 247 448
- US-A1- 2022 057 350

## Description

### Technical field of the invention

The present invention relates to the field of battery management technologies, and specifically to a method for predicting thermal runaway in a lithium battery based on capacitive reactance analysis.

### Background of the invention

Lithium battery energy storage systems are widely applied to transportation, electricity, and other fields. However, because lithium batteries have an inherent thermal runaway safety risk, thermal runaway in lithium batteries cannot be solved thoroughly. In the thermal runaway safety risk, a temperature inside a lithium battery rapidly increases uncontrollably, eventually causing a fire control safety accident. The accurate and beforehand prediction of thermal runaway in a lithium battery is the foundation for avoiding a more severe safety accident in a lithium battery energy storage system. At present, thermal runaway can be nipped in the bud by combining thermal runaway prediction and an energy storage fire control system.

Thermal runaway in a lithium battery is mainly predicted through external representations of the battery when the battery is in an early stage of thermal runaway or is undergoing thermal runaway. The external representations mainly include a temperature signal, a mechanical or pressure signal, a gas signal, and the like. One of the major representations indicating that thermal runaway is about to occur in the battery is a temperature rise. A temperature sensor may be placed on the surface of the battery to measure a temperature to determine changes in a battery temperature. However, the method has problems in two aspects: Only a surface temperature of the battery can be measured in the method. It takes time for a temperature inside the battery to be transferred to the surface, and a temperature sensor needs to be configured for each battery, resulting in high costs. The mechanical or pressure signal and the gas signal are both signs that appear in the early stage of thermal runaway in the lithium battery. When the temperature inside the battery is excessively high, a gas is generated to cause an expansion and a deformation in a casing of the battery, and such a mechanical deformation may be measured by a stress sensor. When the internal pressure reaches a particular degree, the gas is sprayed from a safety valve of the battery. In this case, if the battery is located in a closed container, the pressure inside the container increases, and may be measured by a pressure sensor. The sprayed specific gas may be measured by a corresponding gas sensor. In addition, the sprayed gas is accompanied with smoke, and may be measured by a smoke sensor. It may be found through analysis that in all the methods such as mechanical deformation, pressure increase, gas analysis, smoke sensing, and the like, a signal can be detected only when thermal runaway is about to occur in a lithium battery and there is an obvious sign. Prediction takes place a short time before thermal runaway occurs, and is easily susceptible to interference from the external environment.

In addition to the foregoing methods, equivalent internal resistance of a battery can accurately reflect changes in an internal state of the battery. Thermal runaway in a battery may be predicted according to internal resistance. Equivalent internal resistance data of a battery or a battery module may be obtained through big data analysis of a BMS management system. However, internal resistance of a battery is greatly affected by SOC, a temperature, and other factors, and cannot be readily used as a necessary condition for determining thermal runaway in the battery.

Patent application US 2021/247448 A1, from SIGMASENSE. LLC, Wilmington, DE (US), published on 12 August 2021, entitled "Non-charging based battery monitoring and characterization" discloses a battery characterization system including a drive-sense circuit (DSC), a memory storing operational instructions, and processing module(s) operably coupled to the DSC and the memory. Based on a reference signal, the DSC generates a charge signal, which includes an AC (alternating current) component, and provides the charge signal to a terminal of a battery via a single line and simultaneously senses the charge signal via the single line to detect an electrical characteristic of the battery based on a response of the battery. The DSC generates a digital signal representative of the electrical characteristic of the battery. The processing module(s), based on the operational instructions, generate the reference signal to include a frequency sweep of the AC component of the charge signal (e.g., different frequencies at different times or multiple frequencies simultaneously) and processes the digital signal to characterize the battery across the different respective frequencies and generate spectrum analysis (SA) information of the battery.

### Summary of the invention

To solve the problems that a determination reference cannot be easily detected and prediction is easily susceptible to interference during the prediction of thermal runaway in a lithium battery pack, the present invention provides a method for predicting thermal runaway in a lithium battery based on capacitive reactance analysis.

A method for predicting thermal runaway in a lithium battery based on capacitive reactance analysis is provided. The method for predicting thermal runaway in a lithium battery includes: Step 1: acquiring environmental temperature data, state of charge data, and battery material data of a battery module, and establishing a measurement frequency and a thermal runaway threshold according to a preset expert library; Step 2: measuring a capacitive reactance curve of the battery module at the measurement frequency by using an alternating current injection method; and Step 3: determining a thermal runaway level of the battery module according to the capacitive reactance curve, and performing thermal runaway early warning.

The measuring a capacitive reactance curve of the battery module at the measurement frequency by using an alternating current injection method includes: detecting a capacitive reactance value of a battery cell in the battery module in real time at the measurement frequency by using the alternating current injection method; and solving a capacitive reactance value of the battery module according to the capacitive reactance value of the battery cell, and establishing a capacitive reactance curve of the battery module changing with temperature.

Preferably, the capacitive reactance value of the battery module is calculated by using the following formula: ${Z}_{IE} \approx \frac{1}{jω} \left(\frac{1}{{C}_{ESC 1}}+\frac{1}{{C}_{ESC 2}}+K+\frac{1}{{C}_{ESCn}}\right)$ where *jω* is a complex frequency domain unit; and *C*_{ESCn} is the capacitive reactance value of the battery cell.

Preferably, before the determining a thermal runaway level of the battery module according to the capacitive reactance curve, the method further includes: establishing thermal runaway level states according to the thermal runaway threshold, including: thermal runaway does not occur; a thermal runaway trend appears; and thermal runaway occurs.

Compared with the prior art, the beneficial effects of the present invention are as follows:
The technical solution provided in the present invention includes: acquiring environmental temperature data, state of charge data, and battery material data of a battery module, and establishing a measurement frequency and a thermal runaway threshold according to a preset expert library; measuring a capacitive reactance curve of the battery module at the measurement frequency by using an alternating current injection method; and determining a thermal runaway level of the battery module according to the capacitive reactance curve, and performing thermal runaway early warning. As a battery temperature rises, capacitive reactance changes clearly with temperature, and a capacitive reactance curve of a battery module is measured by using a method for measuring capacitive reactance of a battery cell, so that the occurrence of thermal runaway in a battery can be predicted effectively and in time, to provide more time for fire control intervention of thermal runaway, thereby effectively reducing a loss caused by thermal runaway in the battery, and ensuring the safety of an energy storage system. The principle of detecting the capacitive reactance of the battery module is simple, real-time detection can be implemented by using a BMS system and an MCU controller, and the dependency on detection sensors and equipment is low.

### Brief description of the drawings

FIG. 1 is a flowchart of a method for predicting thermal runaway in a lithium battery according to the present invention;
FIG. 2 is a flowchart of transfer of detection information in a method for predicting thermal runaway in a lithium battery according to the present invention;
FIG. 3 is an effect diagram of capacitive reactance of a lithium battery changing with temperature according to the present invention; and
FIG. 4 is a schematic diagram of composition of a system for predicting thermal runaway in a lithium battery according to an example not part of the present invention.

### Detailed description of the invention

To better understand the present invention, the content of the present invention is further described below with reference to the accompanying drawings and examples of the specification.

### Embodiment:

This embodiment provides a method for predicting thermal runaway in a lithium battery based on capacitive reactance analysis. Before the method is provided, it is found by analyzing a large amount of experimental data that low-frequency impedance of a lithium battery nearly does not change with a state of charge. Therefore, the method for predicting thermal runaway in a lithium battery based on capacitive reactance analysis is researched.

Impedance of a battery includes real-axis impedance and imaginary-axis impedance. In a low-frequency section, the real-axis impedance is mainly represented as resistance, and the imaginary-axis impedance is mainly represented as capacitance. Therefore, a value of an imaginary-axis part of low-frequency impedance may be represented as capacitive reactance. A real-axis value of low-frequency impedance of a battery module is shown by the following formula: ${Z}_{RE} \approx {R}_{ESR 1} + {R}_{ESR 2} + K + {R}_{ESRn}$

In the formula, *Z*_{RE} is the real-axis value of the low-frequency impedance of the battery module, and *R*_{ESRn} is equivalent series internal resistance of a battery cell.

The real-axis value of the low-frequency impedance of the battery module is formed by a sum of resistance of battery cells. Changes in internal resistance of the cells are accumulated into a change in equivalent internal resistance of the battery module. Therefore, a change caused by thermal runaway in a battery cell cannot be determined according to equivalent series internal resistance of a battery pack.

An imaginary-axis value of the low-frequency impedance of the battery module, that is, capacitive reactance, is shown by the following formula: ${Z}_{IE} \approx \frac{1}{jω} \left(\frac{1}{{C}_{ESC 1}}+\frac{1}{{C}_{ESC 2}}+K+\frac{1}{{C}_{ESCn}}\right)$ where *jω* is a complex frequency domain unit; and *C*_{ESCn} is a capacitive reactance value of the battery cell.

The imaginary-axis value of the low-frequency impedance of the battery module is formed by equivalent capacitance of the battery cells in series. Therefore, a capacitive reactance value of the battery module is determined by the smallest cell equivalent capacitance value. That is, a decrease in an equivalent capacitance value of any cell can be represented by capacitive reactance of the battery pack. Due to series connection of equivalent capacitance, a capacitance value after series connection is not determined by the accumulation of capacitance values connected in series, and is mainly determined by a minimum capacitance value. Therefore, a decrease in a capacitance value of a battery cell connected in series in a thermal runaway state may be clearly reflected by a capacitive reactance value of the module.

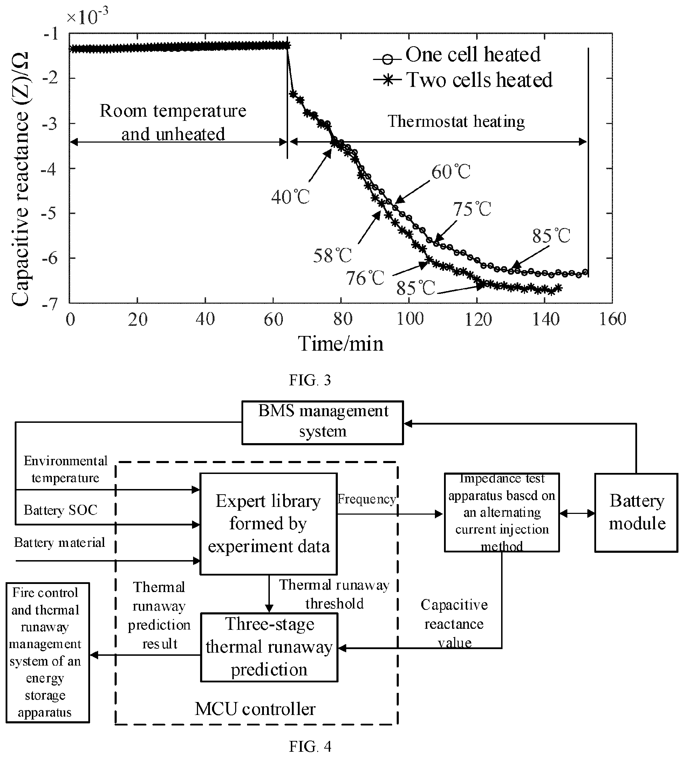

According to this concept, an experiment of simulating thermal runaway in a battery pack is carried out. The battery pack is formed by five 30-Ah lithium iron phosphate battery cells. An effect diagram of capacitive reactance changing with temperature obtained through measurement by heating one cell and heating two cells is shown in FIG. 3. In a heating process, a thermostat is set to 85°C, and the temperature slowly rises, and eventually stabilizes at 85°C. It can be seen that in a heating process of a battery cell, an imaginary-axis value of a low-frequency impedance of the battery pack clearly increases as the temperature of a battery increases, and such an increase trend does not clearly change as a quantity of battery cells being heated increases. Therefore, the imaginary-axis value of the low-frequency impedance of the battery pack may be used for predicting thermal runaway in the battery. An increase in the temperature of any battery is reflected in the imaginary-axis value of the low-frequency impedance, and is therefore detected.

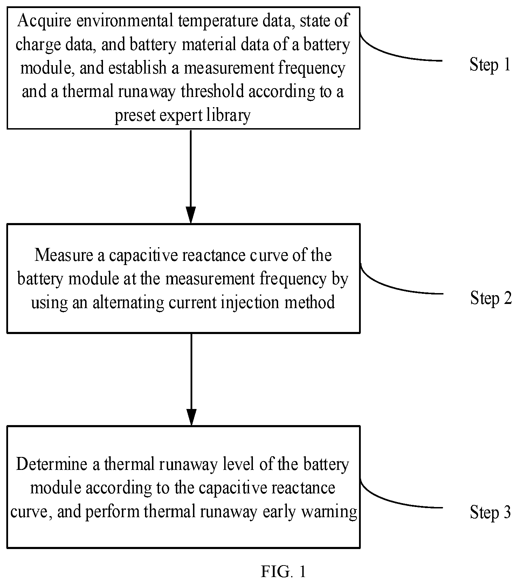

Based on the foregoing analysis, this embodiment provides a method for predicting thermal runaway in a lithium battery based on capacitive reactance analysis. A flowchart of the method is shown in FIG. 1, and includes the following steps.

Step 1: Acquiring environmental temperature data, state of charge data, and battery material data of a battery module, and establish a measurement frequency and a thermal runaway threshold according to a preset expert library. Step 2: Measuring a capacitive reactance curve of the battery module at the measurement frequency by using an alternating current injection method. Step 3: Determining a thermal runaway level of the battery module according to the capacitive reactance curve, and performing thermal runaway early warning.

The measuring a capacitive reactance curve of the battery module at the measurement frequency by using an alternating current injection method includes: detecting a capacitive reactance value of a battery cell in the battery module in real time at the measurement frequency by using the alternating current injection method; and solving a capacitive reactance value of the battery module according to the capacitive reactance value of the battery cell, and establishing a capacitive reactance curve of the battery module changing with temperature.

The capacitive reactance value of the battery module may be calculated by using the following formula: ${Z}_{IE} \approx \frac{1}{jω} \left(\frac{1}{{C}_{ESC 1}}+\frac{1}{{C}_{ESC 2}}+K+\frac{1}{{C}_{ESCn}}\right)$ where *jω* is a complex frequency domain unit; and *C*_{ESCn} is the capacitive reactance value of the battery cell.

Before the determining a thermal runaway level of the battery module according to the capacitive reactance curve, the method further includes: establishing thermal runaway level states according to the thermal runaway threshold, including: thermal runaway does not occur; a thermal runaway trend appears; and thermal runaway occurs.

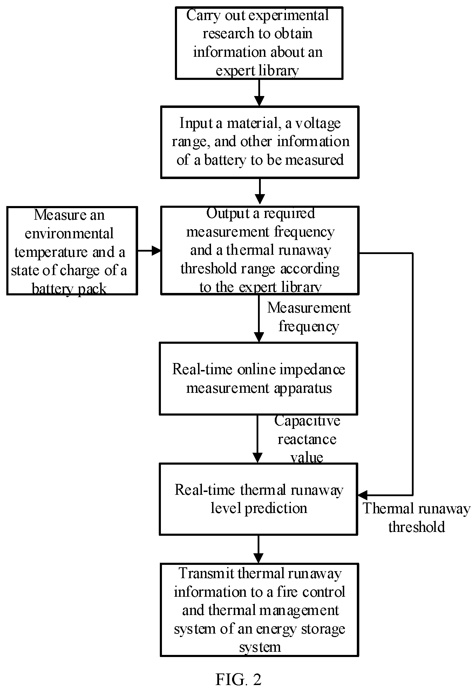

In the foregoing method, a flowchart of transfer of detection information in the method for predicting thermal runaway in a lithium battery is shown in FIG. 2. First, experimental research of critical thermal runaway of batteries of different types at different environmental temperatures and different states of charge is carried out, and information about an expert library is obtained according to experimental data. Then, a material, a voltage range, and other information of a battery to be measured and an environmental temperature, a state of charge, and other information of a battery pack that are measured in real time are inputted into the expert library. The expert library outputs a frequency point of impedance measurement and information about a thermal runaway threshold. Next, a real-time impedance measurement apparatus performs a real-time online test on impedance of the battery pack according to a measurement frequency inputted by the expert library, and outputs a capacitive reactance value. Finally, a real-time thermal runaway level prediction stage is entered, thermal runaway level prediction is performed according to the capacitive reactance value and the thermal runaway threshold, and a prediction result is outputted to a fire control and thermal runaway management system of an energy storage apparatus.

### Example not part of the invention

This example not part of the invention provides a system for predicting thermal runaway in a lithium battery based on capacitive reactance analysis. A schematic diagram of composition of a system for predicting thermal runaway in a lithium battery is shown in FIG. 4. The system includes an MCU controller, an impedance measurement apparatus, a BMS management system, and a thermal runaway management system. The MCU controller is communicatively connected to the BMS management system; and the MCU controller acquires environmental temperature data and state of charge data of a battery module by using the BMS management system, and establishes a thermal runaway threshold and a measurement frequency based on battery material data of the battery module. The MCU controller is communicatively connected to the impedance measurement apparatus, and the impedance measurement apparatus performs capacitive reactance measurement on the battery module at the measurement frequency, transfers a measurement result to the MCU controller, and establishes a capacitive reactance curve of the battery module. The MCU controller is communicatively connected to the thermal runaway management system, and the MCU controller performs thermal runaway early warning according to the capacitive reactance curve by using the thermal runaway management system.

The MCU controller includes an expert library module and a three-stage thermal runaway prediction module. The expert library module establishes the measurement frequency according to the environmental temperature data and the state of charge data from the BMS management system and the battery material data, and sends the measurement frequency to the impedance measurement apparatus; and the expert library module further establishes the thermal runaway threshold, and sends the thermal runaway threshold to the three-stage thermal runaway prediction module. The three-stage thermal runaway prediction module establishes the capacitive reactance curve of the battery module according to the measurement result of the impedance measurement apparatus, establishes a thermal runaway prediction result according to the thermal runaway threshold, and sends the thermal runaway prediction result to the thermal runaway management system.

In the foregoing system, an expert library formed by experimental data and thermal runaway prediction are both implemented in an MCU controller. An environmental temperature of a battery pack and SOC information of the battery pack inputted into the expert library are obtained from a BMS management system in a communication manner, and material information of a battery is manually inputted from outside. Impedance measurement is performed by using an impedance measurement apparatus based on an alternating current injection method. A current frequency injected into the battery pack is outputted from the expert library, and the impedance measurement apparatus outputs a capacitive reactance value to an MCU. Three thermal runaway levels are classified according to a thermal runaway threshold and the capacitive reactance value, which are respectively: thermal runaway does not occur, there is a trend of thermal runaway, and thermal runaway is about to occur. Finally, a thermal runaway result is outputted to a fire control and thermal runaway management system of an energy storage apparatus. For the level that thermal runaway does not occur, no action is required. For the level that there is a trend of thermal runaway, a thermal management system is started to reduce the temperature. For the level that thermal runaway is about to occur, a fire control system is started.

## Claims

1. A method for predicting thermal runaway in a lithium battery in which multiple battery cells are connected in series, based on capacitive reactance analysis, wherein the method for predicting thermal runaway in a lithium battery comprises:
Step 1: acquiring environmental temperature data, state of charge data, and battery material data of a battery module, and establishing a low-frequency measurement frequency and a thermal runaway threshold according to a preset expert library;
Step 2: measuring a capacitive reactance curve of the battery module at the low-frequency measurement frequency by using an alternating current injection method; and
Step 3: determining a thermal runaway level of the battery module according to the capacitive reactance curve, and performing thermal runaway early warning;
**characterized in that** Step 2 of measuring a capacitive reactance curve of the battery module at the low-frequency
measurement frequency by using an alternating current injection method comprises:
detecting a capacitive reactance value of a battery cell in the battery module in real time at the low-frequency
measurement frequency by using the alternating current injection method; and
solving a capacitive reactance value of the battery module according to the capacitive reactance value of the battery cell, and establishing a capacitive reactance curve of the battery module changing with temperature.

2. The method for predicting thermal runaway in a lithium battery according to claim 1, **characterized in that** the capacitive reactance value of the battery module is calculated by using the following formula: ${Z}_{IE} \approx \frac{1}{jω} \left(\frac{1}{{C}_{ESC 1}}+\frac{1}{{C}_{ESC 2}}+K+\frac{1}{{C}_{ESCn}}\right)$ wherein *jω* is a complex frequency domain unit; and *C*_{ESCn} is the capacitive reactance value of the battery cell.

3. The method for predicting thermal runaway in a lithium battery according to claim 1, **characterized in that** before the determining a thermal runaway level of the battery module according to the capacitive reactance curve, the method further comprises:
establishing thermal runaway level states according to the thermal runaway threshold, comprising: thermal runaway does not occur; a thermal runaway trend appears; and thermal runaway occurs.

## Patentansprüche

1. Verfahren zur Vorhersage eines thermischen Durchgehens in einer Lithiumbatterie, bei der mehrere Batteriezellen in Reihe geschaltet sind, auf der Grundlage einer kapazitiver Reaktanzanalyse, wobei das Verfahren zur Vorhersage eines thermischen Durchgehens in einer Lithiumbatterie Folgendes umfasst:
Schritt 1: Erfassen von Umgebungstemperaturdaten, Ladezustandsdaten und Batteriematerialdaten eines Batteriemoduls sowie Festlegen einer Niederfrequenz-Messfrequenz und eines Schwellenwerts für das thermische Durchgehen anhand einer voreingestellten Expertenbibliothek;
Schritt 2: Messen einer kapazitiver Reaktanzkurve des Batteriemoduls bei der Niederfrequenz-Messfrequenz unter Verwendung eines Wechselstrominjektions; und
Schritt 3: Bestimmen eines thermischen Durchlaufniveaus des Batteriemoduls anhand der kapazitiver Reaktanzkurve und Durchführen einer Frühwarnung vor einem thermischen Durchgehen;
**dadurch gekennzeichnet, dass** Schritt 2 des Messens einer kapazitiver Reaktanzkurve des Batteriemoduls bei der Niederfrequenz-Messfrequenz unter Verwendung eines Wechselstrominjektions Folgendes umfasst:
Erfassen eines kapazitiver Reaktanzwerts einer Batteriezelle im Batteriemodul in Echtzeit bei der Niederfrequenz-Messfrequenz unter Verwendung des Wechselstrominjektions; und
Ermitteln eines kapazitiver Reaktanzwerts des Batteriemoduls auf der Grundlage des kapazitiver Reaktanzwerts der Batteriezelle sowie Erstellen einer temperaturabhängigen kapazitiver Reaktanzkurve des Batteriemoduls.

2. Verfahren zur Vorhersage eines thermischen Durchgehens in einer Lithiumbatterie nach Anspruch 1, **dadurch gekennzeichnet, dass** der kapazitiver Reaktanzwerts des Batteriemoduls unter Verwendung der folgenden Formel berechnet wird: ${Z}_{IE} \approx \frac{1}{jω} \left(\frac{1}{{C}_{ESC 1}}+\frac{1}{{C}_{ESC 2}}+K+\frac{1}{{C}_{ESCn}}\right)$ wobei *jω* eine Einheit im komplexen Frequenzbereich ist; und *C*_{ESCn} der kapazitiver Reaktanzwert der Batteriezelle ist.

3. Verfahren zur Vorhersage eines thermischen Durchgehens in einer Lithiumbatterie nach Anspruch 1, **dadurch gekennzeichnet, dass** das Verfahren vor der Bestimmung eines Niveaus des thermischen Durchgehens des Batteriemoduls anhand der kapazitiver Reaktanzkurve ferner umfasst:
Festlegen von Zuständen des Niveaus des thermischen Durchgehens, anhand dem Schwellenwert für das thermische Durchgehen, umfassend: es tritt kein thermisches Durchgehen auf; es zeigt sich ein Trend zum thermischen Durchgehen; und es tritt ein thermisches Durchgehen auf.

## Revendications

1. Procédé de prédiction d'un emballement thermique dans une batterie au lithium dans laquelle plusieurs cellules de batterie sont connectées en série, basé sur l'analyse de la réactance capacitive, dans lequel le procédé de prédiction d'un emballement thermique dans une batterie au lithium comprend :
Étape 1 : acquérir des données de température ambiante, des données d'état de charge et des données de matériau de batterie d'un module de batterie, et établir une fréquence de mesure basse fréquence et un seuil d'emballement thermique selon une bibliothèque experte prédéfinie ;
Étape 2 : mesurer une courbe de réactance capacitive du module de batterie à la fréquence de mesure basse fréquence en utilisant un procédé d'injection de courant alternatif ; et
Étape 3 : déterminer un niveau d'emballement thermique du module de batterie selon la courbe de réactance capacitive, et effectuer une alerte précoce d'emballement thermique ;
**caractérisé en ce que** l'étape 2 consistant à mesurer une courbe de réactance capacitive du module de batterie à la fréquence de mesure basse fréquence en utilisant un procédé d'injection de courant alternatif comprend :
détecter en temps réel une valeur de réactance capacitive d'une cellule de batterie dans le module de batterie à la fréquence de mesure basse fréquence en utilisant le procédé d'injection de courant alternatif ; et
résoudre une valeur de réactance capacitive du module de batterie selon la valeur de réactance capacitive de la cellule de batterie, et établir une courbe de réactance capacitive du module de batterie variant en fonction de la température.

2. Procédé de prédiction d'un emballement thermique dans une batterie au lithium selon la revendication 1, **caractérisé en ce que** la valeur de réactance capacitive du module de batterie est calculée en utilisant la formule suivante : ${Z}_{IE} \approx \frac{1}{jω} \left(\frac{1}{{C}_{ESC 1}}+\frac{1}{{C}_{ESC 2}}+K+\frac{1}{{C}_{ESCn}}\right)$ dans lequel *jω* est une unité du domaine fréquentiel complexe ; et *C*_{ESCn} est la valeur de réactance capacitive de la cellule de batterie.

3. Procédé de prédiction d'un emballement thermique dans une batterie au lithium selon la revendication 1, **caractérisé en ce que**, avant la détermination d'un niveau d'emballement thermique du module de batterie selon la courbe de réactance capacitive, le procédé comprend en outre :
établir des états de niveau d'emballement thermique selon le seuil d'emballement thermique, comprenant : l'emballement thermique ne se produit pas; une tendance à l'emballement thermique apparaît ; et l'emballement thermique se produit.
